# EUROPEAN PATENT APPLICATION

(11) **EP 1 491 963 A2**
(43) Date of publication of application: **29.12.2004**
(21) Application number: 04076841.8
(22) Date of filing: 24.06.2004
(51) Int. Cl.: G03F 7/20

(54) **Laser produced plasma radiation system with contamination barrier**

(30) Priority: 27.06.2003 EP 03077012
(71) Applicant: ASML Netherlands B.V., 5504 DR Veldhoven (NL)
(72) Inventor: Bakker, Levinus Pieter, 5708 ZT Helmond (NL); Banine, Vadim Yevgenyevich, 5704 NK Helmond (NL); Kurt, Ralph, 5655 CG Eindhoven (NL); Schuurmans, Frank Jeroen Pieter, 5551 XE Valkenswaard (NL); Sidelnikov, Yurii Victorovitch, Troitsk, 142190 Moscow (RU)
(74) Representative: van Westenbrugge, Andries

(57) **Abstract**

A radiation system (20) is presented with a foil trap (24) between a collector, such as a Normal Incidence collector (22), and a (plasma) light source (32), such that radiation coming from the light source passes the foil trap twice. Once before hitting the collector, and the second time, after reflection by the collector. This configuration was believed not to be possible in the past. Since the foil trap comprises lamellas that are parallel to both the radiation coming from the light source, and to the radiation reflected by the collector, the radiation is not obstructed by the foil trap. In this way, a Normal Incidence collector which is used with a plasma produced source, can be protected from debris coming from a EUV source.

## Description

The present invention relates to a radiation system for providing a projection beam of radiation comprising:
- a radiation source;
- a collector for focussing radiation coming from the radiation source;
- a contamination barrier for trapping contamination particles coming from the radiation source, the foil trap being positioned between the radiation source and the collector, so as to pass through radiation coming from the radiation source.

The invention also relates to a lithographic projection apparatus comprising:
- a radiation system as described above;
- a support structure for supporting patterning means, the patterning means serving to pattern the projection beam according to a desired pattern;
- a substrate table for holding a substrate; and
- a projection system for projecting the patterned beam onto a target portion of the substrate.

Finally, the invention relates to a device manufacturing method comprising the steps of:
- providing a substrate that is at least partially covered by a layer of radiation-sensitive material;
- providing a projection beam of radiation using a radiation system as described above;
- using patterning means to endow the projection beam with a pattern in its cross-section; and
- projecting the patterned beam of radiation onto a target portion of the layer of radiation-sensitive material.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localised electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required; and
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus ― commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel or preparatory steps may be carried out on one or more tables while one or more other tables are being used for exposures. Dual stage lithographic apparatus are described, for example, in US 5,969,441 and WO 98/40791, both incorporated herein by reference.

A radiation system as described in the preamble is known from, for example, US 6.359.969 B1. The radiation system comprises a foil trap wherein each lamella essentially points in a radial direction when viewed from the radiation source. In this way, the radiation coming from the radiation source, is not (or little) obstructed by the lamellas, while debris coming from the radiation source, will be captured on the lamellas. In other words, the lamellas are focussed with a focus at the position of the radiation source.

Up to now, there has been consensus among the laser-produced extreme ultra violet (EUV) source suppliers, that it is not possible to use the foil trap technique to protect a normal incidence (NI) collector from source-produced debris. The reason for this is the fact that the EUV beam as produced by the radiation source has to pass a foil trap twice, i.e. first from the radiation source to the normal incidence collector, and then for a second time, as a reflected beam, away from the NI-collector. This is not possible with a foil trap in which all the lamellas are focussed to one particular point, as described in US 6.359.969 B1.

It is an object of the present invention to introduce a foil trap into a radiation system with a normal incidence collector. This object is achieved according to the invention in a radiation system as specified in the opening paragraph, characterised in that the collector is arranged so that radiation reflected by the collector will pass the contamination barrier and wherein the contamination barrier comprises a plurality of lamellas positioned in respective planes which are parallel to a propagation direction of the reflected radiation. The contamination barrier, i.e. the foil trap, is arranged in a way that light may pass the foil trap twice, with minimal obstruction of the lamellas. Known foil traps have lamellas which are focussed to the light source, so light can only pass the foil trap once.

In a first embodiment, the collector is arranged such that the incident radiation coming from the radiation source, is substantially normal to a surface of the collector, the collector having a curved inner surface defining an imaginary ellipsoidal with a first and a second focus, the radiation source being situated in the first focus, and wherein the respective planes of the lamellas all intersect at a line through the first and second focus. In this embodiment the collector is called a Normal Incidence (NI) collector. The radiation system is able to produce a focussed beam of radiation in the second focus point while the foil trap will protect the collector from being contaminated by particles from the radiation source.

In a particular embodiment, the radiation source comprises a laser produced plasma source. A laser produced plasma source is actually a 'free standing' point source, so radiation reflected by the NI-collector is not obstructed by any arrangement producing the radiation.

In another embodiment, the contamination barrier comprises an outer ring for supporting the lamellas, the outer ring having a minimal diameter so that the outer ring is situated outside a conus formed by a circumference of the collector and the second focus. In this way, the outer ring is kept out of the beam, and reflected radiation is not obstructed in any way by the outer ring.

In yet another embodiment, the outer ring is shaped as a slice of a cone, the cone having its tip at approximately the position of the radiation source. In this way, the surface of the outer ring facing the source is minimal, so heat production in the outer ring is kept to a minimum.

The contamination barrier may comprise an inner ring for supporting the lamellas, the inner ring being shaped as a slice of a cone having its tip at approximately the position of the radiation source. The inner ring needs to be as small as possible as to not obstruct the radiation beam; the lower limit of the dimensions of the inner ring is the fact that enough space should be available to support the lamellas. A conical ring is favourable in this situation.

The present invention also relates to a lithographic projection apparatus, comprising:
- a radiation system according as described above;
- a support structure for supporting patterning means, the patterning means serving to pattern the projection beam according to a desired pattern;
- a substrate table for holding a substrate; and
- a projection system for projecting the patterned beam onto a target portion of the substrate.

The present invention also relates to a device manufacturing method comprising:
- providing a substrate that is at least partially covered by a layer of radiation-sensitive material;
- providing a projection beam of radiation using a radiation system as described above;
- using patterning means to endow the projection beam with a pattern in its cross-section; and
- projecting the patterned beam of radiation onto a target portion of the layer of radiation-sensitive material.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet (UV) radiation (e.g. with a wavelength of 365, 248, 193, 157 or 126 nm) and extreme ultra-violet (EUV) radiation (e.g. having a wavelength in the range 5-20 nm), as well as particle beams, such as ion beams or electron beams.

Embodiments of the invention will now be described, by way of example only, with reference to the accompanying schematic drawings in which corresponding reference symbols indicate corresponding parts, and in which:
- Figure 1 schematically depicts a lithographic projection apparatus according to an embodiment of the invention;
- Figure 2 depicts a side view of a part of a radiation system according to the invention;
- Figure 3 shows a front view and a cross-sectional view, respectively, of the foil trap of figure 2;
- Figure 4 shows a front view and a cross-sectional view, respectively, of another embodiment of a foil trap;
- Figure 5A shows a cross-sectional view of a flat surface of a lamella of a foil trap, according to the state of the art;
- Figure 5B shows a cross-sectional view of a roughened surface of a lamella of a foil trap, according to the state of the art;
- Figures 5C, 5D show a cross-sectional view of a roughened surface of a lamella of a foil trap, according to the invention;
- Figure 6 depicts an example of a foil trap with a rod shaped magnet inside, to produce a radial magnetic field;
- Figure 7 shows the magnet of figure 6 in more detail, and
- Figure 8 shows a foil trap with charged lamellas to produce an electrical field.

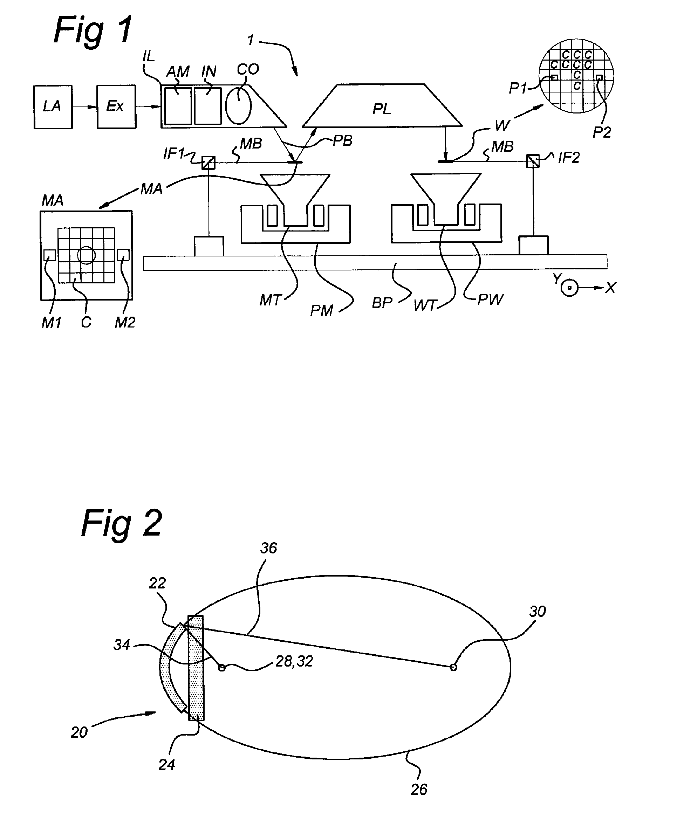

Figure 1 schematically depicts a lithographic projection apparatus 1 according to an embodiment of the invention. The apparatus comprises:
- a radiation system Ex, IL, for supplying a projection beam PB of radiation (e.g. EUV radiation). In this particular case, the radiation system also comprises a radiation source LA;
- a first object table (mask table) MT provided with a mask holder for holding a mask MA (e.g. a reticle), and connected to first positioning means PM for accurately positioning the mask with respect to item PL;
- a second object table (substrate table) WT provided with a substrate holder for holding a substrate W (e.g. a resist-coated silicon wafer), and connected to second positioning means PW for accurately positioning the substrate with respect to item PL; and
- a projection system ("lens") PL (e.g. mirrors) for imaging an irradiated portion of the mask MA onto a target portion C (e.g. comprising one or more dies) of the substrate W.

As here depicted, the apparatus is of a reflective type (i.e. has a reflective mask). However, in general, it may also be of a transmissive type, for example (with a transmissive mask). Alternatively, the apparatus may employ another kind of patterning means, such as a programmable mirror array of a type as referred to above.

The radiation source LA produces a beam of EUV radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to figure 1 that the radiation source LA may be within the housing of the lithographic projection apparatus, but that it may also be remote from the lithographic projection apparatus, the radiation beam which it produces being led into the apparatus (e.g. with the aid of suitable directing mirrors).

The beam PB subsequently intercepts the mask MA, which is held on a mask table MT. Having passed the mask MA, the beam PB passes through the lens PL, which focuses the beam PB onto a target portion C of the substrate W. With the aid of the second positioning means PW (and interferometric measuring means IF), the substrate table WT can be moved accurately, e.g. so as to position different target portions C in the path of the beam PB. Similarly, the first positioning means PM can be used to accurately position the mask MA with respect to the path of the beam PB, e.g. after mechanical retrieval of the mask MA from a mask library, or during a scan. In general, movement of the object tables MT, WT will be realised with the aid of a long-stroke module (coarse positioning) and a short-stroke module (fine positioning), which are not explicitly depicted in figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:
1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB; and
2. In scan mode, essentially the same scenario applies, except that a given target portion C is not exposed in a single "flash". Instead, the mask table MT is movable in a given direction (the so-called "scan direction", e.g. the y direction) with a speed v, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

Figure 2 diagrammatically depicts a cross-sectional view of a radiation system 20 according to an embodiment of the invention comprising a NI-collector 22 (NI = Normal Incidence) and foil trap 24. An inner surface of the NI-collector 22 is curved defining an ellipsoidal 26. The ellipsoidal 26 comprises two foci 28, 30, see figure 2. In focus 28 nearest to the NI-collector 22, a radiation source 32 is situated. In an embodiment, the radiation source 32 comprises a laser produced plasma source 32. In figure 2, an EUV-ray 34, 36 is depicted which is focussed in focus 30 by the NI-collector 22. An incident ray 34 is emitted by the radiation source 32 and hits the NI-collector 22. The foil trap 24 is situated between the radiation source 32 and the NI-collector 22. So, the incident ray 34 will pass the foil trap 24 for the first time on its way to the NI-collector 22. After being reflected by the NI-collector 22, the incident ray 34 becomes a reflected ray 36 which will pass the foil trap 24 on its way to the focus 30. So radiation will pass the foil trap 24 twice. Note that the incident ray 34 and the reflected ray 36 lie in a plane that intersects a line through the foci 28 and 30. Due to the arrangement of the foil trap 24, the foil trap 24 will not obstruct the radiation.

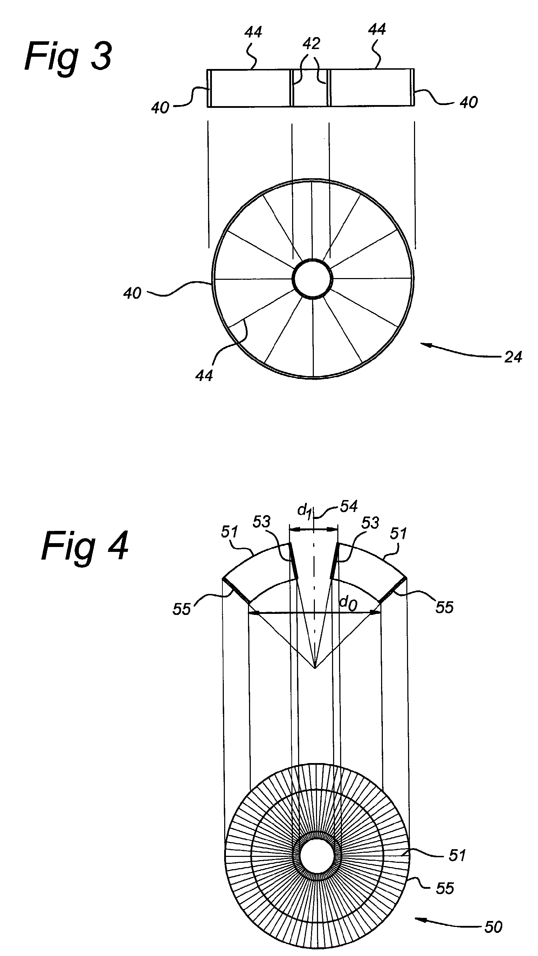

Figure 3 shows a front view and a cross-sectional view, respectively, of the foil trap 24. The foil trap 24 comprises an outer ring 40 and an inner ring 42 for supporting lamellas 44. The outer ring 40 has a minimal diameter so that the outer ring 40 is situated outside a cone formed by a circumference of the NI-collector 22 and the focus 30. Note that this cone is depicted by the EUV-ray 36 in figure 2. It this way, the outer ring 40 will not obstruct any radiation to or from the NI-collector 22. Figure 3 also shows a cross section of the foil trap 24. In this embodiment, the lamellas 44 are essentially rectangular. The inner and outer rings 40, 42 are cylindrical. In this way, a very simple foil trap is arranged.

Figure 4 shows a front view and a cross-sectional view, respectively, of another embodiment of a foil trap 50. The foil trap 50 comprises a plurality of curved lamellas 51. The foil trap 50 further comprises an inner ring 53 and an outer ring 55. The inner ring 53 and the outer ring 55 are shaped as slices of a cone, wherein a minimum diameter d₀ of the outer ring 55 is larger than a maximum diameter dᵢ of the inner ring 53. Both conical rings 53, 55 share the same main axis 54. Furthermore, surfaces of the rings 53, 55 point to one central point 57. In the radiation system 20, the radiation source 32 is approximately positioned in the central point 57 of the rings 53, 55. This position 57 also corresponds to the first focus 28 of the NI-collector 20. The conical inner and outer rings 53, 55 face the radiation source with their edges. This means that little radiation will hit the rings 53, 55 so that heat production in the rings 53, 55 is minimised. A further advantage of a conical inner ring 53 is that this ring needs to be as small as possible since it obstructs radiation coming from the NI-collector 22. But if the inner ring 53 is too small, it will not be possible to connect lamellas 51 to the inner ring 53. Note that the lamellas 51 have a certain thickness, so the number of lamellas being attached to the inner ring 53 will be limited if the surface of the inner ring 53 is small. If the inner ring 53 is conical, the mean diameter of the inner ring 53 can be small while the maximum diameter, i.e. the diameter at the NI-collector facing side of the inner ring 53 can be sufficiently large to receive all the lamellas 51.

In an embodiment, the inner and outer edges of the lamellas 51 are curved in their respective planes so that the nearest edge to the radiation source 32 is essentially circular, see figure 4. In this way the radiation source facing edges of the lamellas 51 will be equally distant from the radiation source 32, and this on its turn, results in a uniform heating of the lamellas 51, which is favourable to minimise mechanical stress in the lamellas 51.

As mentioned above, the rings 40, 42, 53, 55 support the lamellas in such a way that both the incident and the reflected ray 34, 36 are obstructed as little as possible, i.e. the support structure (i.e. the rings) is kept out of the beam. Note that only a small part of the radiation near a main axis of the foil trap 42, 50 is blocked by the inner ring 42, 53 of the foil trap 24, 50. It will be clear to a person skilled in the art that the outer ring 40, 55 will be supported by a wall or another type of structure. The inner ring 42, 53 however may also be free, i.e. only supported/positioned by the lamellas 44, 51.

By roughening the lamellas, the suppression of fast particles (e.g. Xe particles) coming from a radiation source in a lithographic apparatus is increased considerably. Today's design of a foil trap does not facilitate the suppression, i.e. removal and/or slow down, of fast Xe particles emitted by a radiation source.

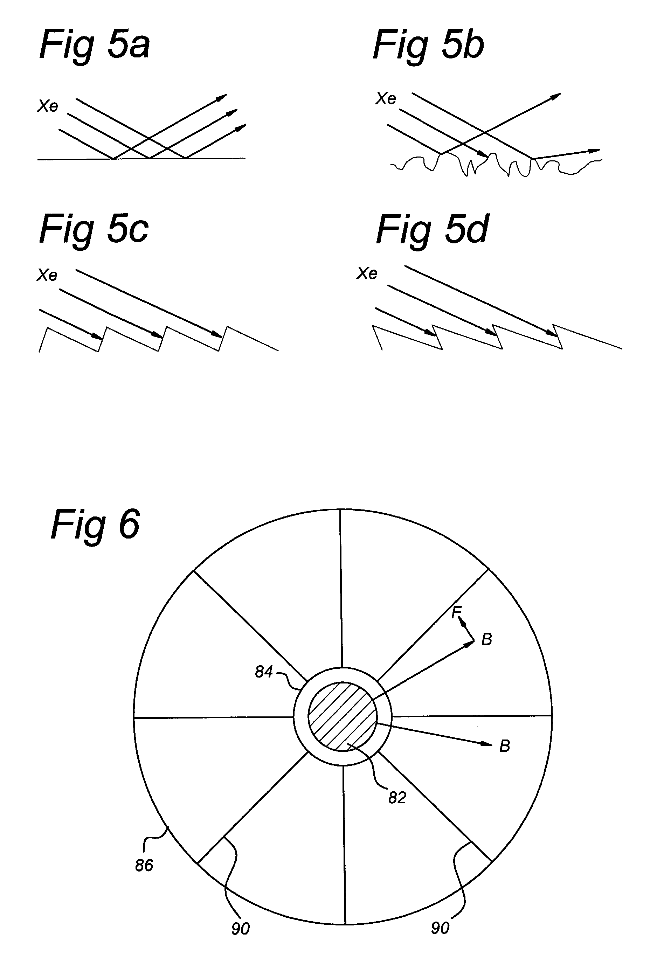

Firstly, this is because the sticking probability of Xe is about zero (instead of close to 1 for atomic Molybdenum or Tungsten). Secondly, the fast Xe particles either do not meet the lamellas of the foil trap at all, or they impinge under a very grazing angle (as they follow a straight path from the radiation source, just like the light) with the lamellas, in which case they are predominantly specularly reflected (without losing significantly in kinetic energy), see figure 5A.

Roughened structures can be made relatively easy. The rough surface can be obtained by regular sand blasting. One should note that the platelets used today are cut out of just off-the-shelf sheet metal, which have significant amount of surface roughness by itself. Due to a roughened surface, the reflection of the Xe particles is reduced, compared to a flat surface. But still, Xe particles will reflect form such a surface, see figure 5B.

Therefore, in a further aspect of the invention, a foil trap is provided comprising lamellas, the surface of which is jagged. In an embodiment, the surface of the lamellas is structured like saw teeth. The idea is based on the fact that a fast Xe particle at grazing incidence angle is reflected off a surface, whereas under more perpendicular incidence the particle is absorbed. By making the surface of the lamellas such that the Xe particles rarely impinge on the surface at grazing angles, most Xe particles will be absorbed, or stopped (loss of kinetic energy) and hence the sputtering problem for down stream optics is reduced. A sketch of this variant of such a surface is given in figure 5C.

The original structure of the surface will, upon sputtering by the fast Xe particles, change over time. However, it is well known that the surface roughness increases while exposed to fast particles, especially for ductile materials like metals. Further, one needs to ensure only a minimal amount of sputtered material will redeposit on the optics.

A particular embodiment of the surface structure, depicted in figure 5D, could minimize this problem, as the redeposition of sputtered material will predominantly take place in trenches of the surface.

A drawback of the structured lamellas shown in figure 5C, may be that the absorption of the Xe particle results in sputtering of the lamella, whereas for a flat surface the sputtering is minimal. However, the lamella is predominantly sputtered at the entrance (i.e. the radiation source facing side) of the foil trap, and thus, given the high aspect ratio of the ducts of the foil trap, the likelihood of the sputtered material reaching the optics is small.

The regular structures of figure 5C and 5D, could be manufactured using diamond tooling, directional plasma etching, or even a replication method. For example, scratching the surface with a diamond tip, as is done for blazed gratings, is relatively easy. Another option is 'stamping' as is done with coins. From a practical standpoint, the rough surface (figure 5B) is implemented easiest.

It is noted that US 6.359.969 B1 also mentions the roughening of the surfaces of the lamellas, but it is not disclosed anywhere how the roughening looks nor how it is realised.

To make a foil trap more effective, fast Xe particles should hit the lamellas. In order to ensure this, the particles can be given an azimuthal component in the velocity. Therefore, according to a further aspect of the invention, a foil trap is provided, wherein a force field is applied to particles that pass the lamellas of the foil trap. In an embodiment, the force field is a radial magnetic field, resulting in an azimuthal Lorentz-force on the Xe particles. The radial magnetic field may be produced with a rod-shaped magnet in the centre of the foil trap. Another possibility is to produce the radial magnetic field with an electromagnet.

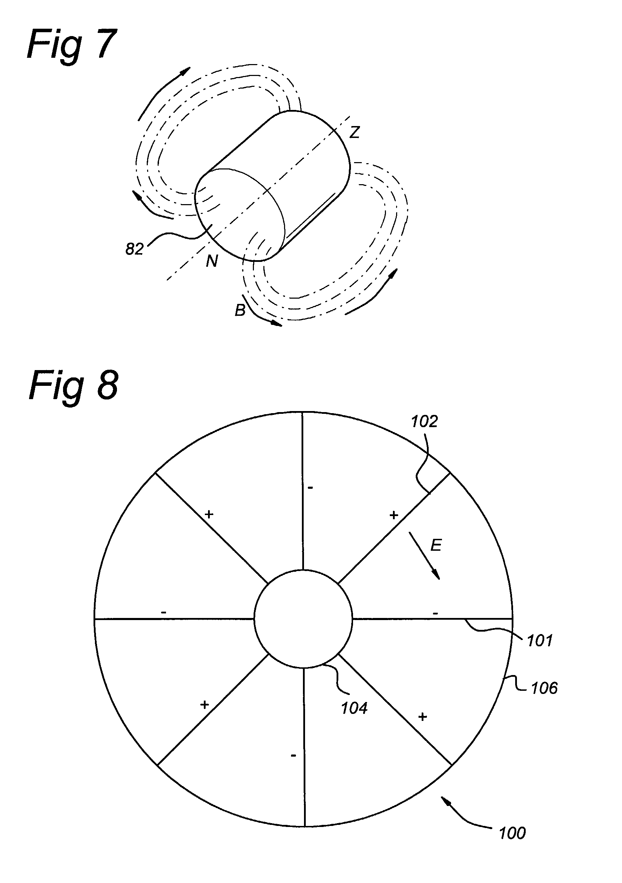

Figure 6 shows a foil trap 80 with a rod-shaped magnet 82 within an inner ring 84 of the foil trap. Lamellas 90 are supported by the inner ring 84 and an outer ring 86. Figure 7 shows the rod-shaped magnet 82 in more detail. The rod-shaped magnet is mounted in such a way that it has one pole at the source side of the foil trap, and one pole at the collector side of the foil trap. Note that the magnetic field near a pole of the magnet is radial. This radial magnetic field cause a Lorentz force F, see figure 6, onto a passing charged particle, like a positively charged Xe particle. So, the particles will get an azimuthal velocity component. This will increase the number of Xe particles that hit a lamella 90, see figure 6. Other magnet configurations are possible, like for example a horse-shoe shaped magnet with one pole on the optical axis and another pole outside the foil trap. In that case, the magnet should be very thin in between the poles to minimize obstruction of the radiation passing the foil trap.

It will be clear that instead of to a 'non focussed foil trap', the principle of using a magnetic field in or near a foil trap also applies to other foil traps, like the 'focussed' foil trap described in US 6.359.969 B1. But now, instead of realizing an azimuth Lorentz-force on the Xe particles, a radial Lorentz-force must be realized.

In another embodiment, the force field comprises an electrical field, created by the lamellas, which are alternately charged positive and negative. In this embodiment, the lamellas may be formed as is described in figure 3 or 4, but other configurations are possible. In figure 8, an embodiment of a foil trap 100 is shown, wherein lamellas 101, 102 are radially directed as seen from a main axis of the foil trap 100. The lamellas 101, 102 are supported by an inner ring 104 and an outer ring 106. The lamellas 101, 102 are alternately charged positively or negatively. In figure 8, the lamellas 101 are charged negatively, and the lamellas 102 are charged positively. Charging of the lamellas 101, 102 can be realized by applying appropriate voltages, as will be clear to a person skilled in the art. In figure 8 the direction of the electric field is shown by a vector E. The electric field will, for example, cause a positive Xe particle to turn off in the direction of a negatively charged lamella 101. This will increase the number of Xe particles that hit a lamella 101 of the foil trap 100.

Whilst specific embodiments of the invention have been described above, it will be appreciated that the invention may be practised otherwise than as described. The description is not intended to limit the invention. For example, a second foil trap on the opposite side of the radiation source 32 is also possible. This second foil trap will capture yet another amount of debris. This will minimize debris in the direction of the focus 30, see figure 2. Finally, it should be noted that the invention is not limited to ellipsoidal shaped collectors. It is clear for the skilled person that other curved collectors are possible as well.

## Claims

1. A radiation system (20) for providing a projection beam of radiation comprising:
- a radiation source (32);
- a collector (22) for collecting radiation coming from said radiation source (32);
- a contamination barrier (24) for trapping contamination particles coming from said radiation source (32), said foil trap being positioned between said radiation source (32) and said collector (22), so as to pass through radiation (34) coming from said radiation source (32),
**characterised in that** said collector (22) is arranged so that radiation (36) reflected by said collector will pass said contamination barrier (24) and wherein said contamination barrier comprises a plurality of lamellas (44; 51) positioned in respective planes which are parallel to a propagation direction of said reflected radiation (36).

2. Radiation system according to claim 1, wherein said collector (22) is arranged such that the incidence of said radiation coming from said radiation source (32), is substantially normal to a surface of said collector (22), said collector (22) having a curved inner surface defining an imaginary ellipsoidal with a first and a second focus (28, 30), said radiation source (32) being situated in said first focus, and wherein said respective planes of said lamellas (44, 51) all intersect at a line through said first and second focus (28, 30).

3. Radiation system according to claim 1 or 2, wherein said radiation source comprises a laser produced plasma source (32).

4. Radiation system according to any of the preceding claims, wherein said contamination barrier (24) comprises an outer ring for supporting said lamellas, said outer ring having a minimal diameter so that said outer ring is situated outside a conus formed by a circumference of said collector (22) and said second focus (30).

5. Radiation system according to claim 4, wherein said outer ring is shaped as a slice of a cone.

6. Radiation system according to any of the preceding claims, wherein said contamination barrier comprises an inner ring for supporting said lamellas, said inner ring being shaped as a slice of a cone having its tip at approximately the position of said radiation source (32).

7. A lithographic projection apparatus comprising:
- a radiation system (20) according to any of the preceding claims;
- a support structure (MT) for supporting patterning means, the patterning means serving to pattern the projection beam according to a desired pattern;
- a substrate table (WT) for holding a substrate; and
- a projection system (PL) for projecting the patterned beam onto a target portion of the substrate.

8. A device manufacturing method comprising:
- providing a substrate that is at least partially covered by a layer of radiation-sensitive material;
- providing a projection beam of radiation using a radiation system according to any of the claims 1-6;
- using patterning means to endow the projection beam with a pattern in its cross-section; and
- projecting the patterned beam of radiation onto a target portion of the layer of radiation-sensitive material.

9. A contamination barrier comprising a plurality of the lamellas the surface of which are rough, **characterized in that** the surface of said plurality of the lamellas is jagged.

10. A contamination barrier (80, 100) comprising a plurality of the lamellas (90, 101, 102), wherein a said contamination barrier (80) is arranged to apply a force field to particles that pass said plurality of the lamellas (90, 101, 102), such that said particles develop a velocity perpendicular to surfaces of said plurality of the lamellas (90, 101, 102).

11. Radiation system according to any of the claims 1-6, wherein said lamellas have an approximately rectangular shape.

12. Radiation system according to any of the claims 1-6, wherein said lamellas have curved inner and outer edges in said respective planes so that the nearest edge to said radiation source (32) is essentially circular.

13. Radiation system according to claim 5, wherein said cone has its tip at approximately the position of said radiation source (32).

14. Contamination barrier according to claim 9, wherein said jagged surface comprises sawtooth like structures.

15. Contamination barrier according to claim 14, wherein said sawtooth like structures comprise tips which lean over.

16. Contamination barrier (80) according to claim 10, wherein said contamination barrier (80) comprises a magnet for producing a magnetic field.

17. Contamination barrier (80) according to claim 16, wherein said plurality of lamellas (90) are positioned in respective planes which radially extend from a main axis of said contamination barrier (80), and wherein said magnet is arranged to produce a radial magnetic field between said plurality of lamellas (90).

18. Contamination barrier (80) according to claim 10, wherein said lamellas (101, 102) are arranged to produce an electric force field between said lamellas (101, 102).

19. Contamination barrier (100) according to claim 18, wherein said plurality of lamellas (101, 102) are positioned in respective planes which radially extend from a main axis of said contamination barrier (100), and wherein said plurality of lamellas (101, 102) are alternately charged positive and negative.

20. A lithographic projection apparatus comprising:
- a radiation system for providing a projection beam of radiation;
- a support structure (MT) for supporting patterning means, the patterning means serving to pattern the projection beam according to a desired pattern;
- a substrate table (WT) for holding a substrate; and
- a projection system (PL) for projecting the patterned beam onto a target portion of the substrate,
wherein said radiation system comprises a contamination barrier according to claims 10, 14, 15, 16, 17, 18 or 19.

21. A device manufacturing method comprising:
- providing a substrate that is at least partially covered by a layer of radiation-sensitive material;
- providing a projection beam of radiation using a radiation system;
- using patterning means to endow the projection beam with a pattern in its cross-section; and
- projecting the patterned beam of radiation onto a target portion of the layer of radiation-sensitive material,
wherein said radiation system comprises a contamination barrier according to claims 10, 14, 15, 16, 17, 18 or 19.
